(19)

Europäisches Patentamt

European Patent Office

Office européen des brevets

(11) **EP 4 722 809 A2**

(12) **EUROPEAN PATENT APPLICATION**

(43) Date of publication:
08.04.2026 Bulletin 2026/15

(21) Application number: 26159001.2

(22) Date of filing: 17.02.2026

(51) International Patent Classification (IPC):
*G03F 7/00* (2006.01)     *G03F 9/00* (2006.01)

(52) Cooperative Patent Classification (CPC):
G03F 7/707; G03F 9/7034

(84) Designated Contracting States:
AL AT BE BG CH CY CZ DE DK EE ES FI FR GB GR HR HU IE IS IT LI LT LU LV MC ME MK MT NL NO PL PT RO RS SE SI SK SM TR
Designated Extension States:
BA
Designated Validation States:
GE KH LA MA MD TN

(71) Applicant: ASML Netherlands B.V.
5500 AH Veldhoven (NL)

(72) Inventors:
• WOLFGRAMM, Florian
5500 AH Veldhoven (NL)

• NIKOLAY, Niko
5500 AH Veldhoven (NL)
• SELIG, Malte
5500 AH Veldhoven (NL)
• BURGARTH, Volker
5500 AH Veldhoven (NL)
• BEZOLD, Steffen
5500 AH Veldhoven (NL)
• DRENDEL, Jan, Uwe
5500 AH Veldhoven (NL)

(74) Representative: ASML Netherlands B.V.
Corporate Intellectual Property
P.O. Box 324
5500 AH Veldhoven (NL)

(54) **METHODS OF MEASURING FLATNESS OF A SUBSTRATE SUPPORT OF A LITHOGRAPHY APPARATUS**

(57)     Disclosed is a method of measuring a topography of a substrate support. The method comprises obtaining metrology data describing a topography of a substrate when clamped to the substrate support; obtaining top surface topography data and bottom surface topography data; applying a first transfer function to the bottom surface topography data to obtain processed bottom surface topography data, the first transfer function removing and/or damping topography from the bottom surface which does not transfer to the top surface when the substrate is clamped; determining corrected metrology data, corrected for a contribution of the metrology data attributable to the substrate, from a combination of the top surface topography data and the processed bottom surface topography data; and determining the topography of the substrate support from the corrected metrology data.

Fig. 6

## Description

BACKGROUND

Field of the Invention

The present invention relates to methods and apparatus usable, for example, in the manufacture of devices by lithographic techniques, and to methods of manufacturing devices using lithographic techniques.

Background Art

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. including part of a die, one die, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. These target portions are commonly referred to as "fields".

In the manufacture of complex devices, typically many lithographic patterning steps are performed, thereby forming functional features in successive layers on the substrate. A critical aspect of performance of the lithographic apparatus is therefore the ability to place the applied pattern correctly and accurately in relation to features laid down (by the same apparatus or a different lithographic apparatus) in previous layers. For this purpose, the substrate is provided with one or more sets of alignment marks. Each mark is a structure whose position can be measured at a later time using a position sensor, typically an optical position sensor. The lithographic apparatus includes one or more alignment sensors by which positions of marks on a substrate can be measured accurately. Different types of marks and different types of alignment sensors are known from different manufacturers and different products of the same manufacturer.

In device manufacturing methods using lithographic apparatus, an important factor is the yield, i.e. the percentage of correctly manufactured devices, is the accuracy within which layers are printed in relation to layers that have previously been formed. This is known as overlay and the overlay error budget will often be 10nm or less. To achieve such accuracy, the substrate must be aligned to the reticle pattern to be transferred with great accuracy.

The process in which features with dimensions smaller than the classical resolution limit of a lithographic projection apparatus are printed, is commonly known as low-k, lithography, according to the resolution formula $CD=k1\times\lambda/NA$, where $\lambda$ is the wavelength of radiation employed (currently in most cases 248 nm or 193 nm), NA is the numerical aperture of projection system in the lithographic projection apparatus, CD is the "critical dimension"-generally the smallest feature size printed-and kl is an empirical resolution factor. In general, the smaller k1 the more difficult it becomes to reproduce a pattern on the substrate that resembles the shape and dimensions planned by a designer in order to achieve particular electrical functionality and performance.

It is required to measure the topography or flatness of a substrate support or wafer table, against which a wafer is clamped during alignment metrology and lithographic exposure. Such wafer table topography metrology may be performed as part of a wafer table finishing step, e.g., to perform flatness corrections to the wafer table and/or to determine metrology corrections (e.g., alignment corrections) which aim to remove any wafer table contribution to measurement of the clamped wafer prior to exposure.

It is desirable to improve on present methods of wafer table topography metrology.

SUMMARY OF THE INVENTION

The invention in a first aspect provides a method of measuring a topography of a substrate support, the method comprising: obtaining metrology data describing a topography of a substrate when clamped to the substrate support, the substrate when clamped comprising a bottom surface clamped against the substrate support and a top surface which is measured to obtain the measurement data; obtaining top surface topography data describing a topography of the top surface of the substrate and bottom surface topography data describing a topography of the bottom surface of the substrate; applying a first transfer function to the bottom surface topography data to obtain processed bottom surface topography data, the first transfer function removing and/or damping topography from the bottom surface which does not transfer to the top surface when the substrate is clamped; determining corrected metrology data, corrected for a contribution of the metrology data attributable to the substrate, from a combination of the top surface topography data and the processed bottom surface topography data; and determining the topography of the substrate support from the corrected metrology data.

The above and other aspects of the invention will be understood from a consideration of the examples described below.

BRIEF DESCRIPTION OF THE DRAWINGS

Embodiments of the invention will now be described, by way of example only, with reference to the accompanying drawings, in which:

Figure 1 depicts a lithographic apparatus;

Figure 2 illustrates schematically measurement and exposure processes in the apparatus of Figure 1;

Figure 3 illustrates schematically a known, frequently encountered, wafer topography;

Figure 4 illustrates schematically a known method for measuring flatness of a wafer table using a wafer in an ideal case;

Figure 5 illustrates schematically an issue with the known method of Figure 4 in a real world example;

Figure 6 is a flowchart of a method as disclosed herein, according to a first example; and

Figure 7 is a flowchart of a method as disclosed herein, according to a second example.

## DETAILED DESCRIPTION OF EMBODIMENTS

Before describing embodiments of the invention in detail, it is instructive to present an example environment in which embodiments of the present invention may be implemented.

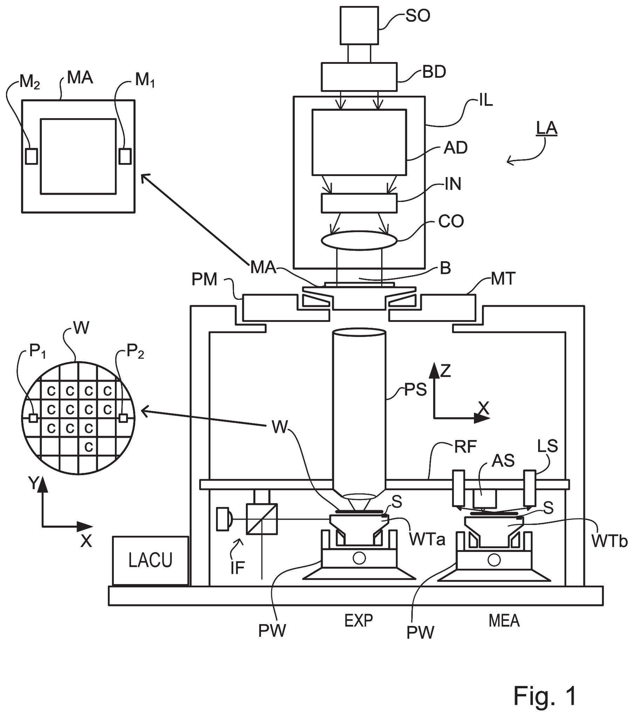

Figure 1 schematically depicts a lithographic apparatus LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; two substrate tables (e.g., a wafer table) WTa and WTb each constructed to hold a substrate (e.g., a resist coated wafer) W and each connected to a second positioner PW configured to accurately position the substrate in accordance with certain parameters; and a projection system (e.g., a refractive projection lens system) PS configured to project a pattern imparted to the radiation beam B by patterning device MA onto a target portion C (e.g., including one or more dies) of the substrate W. A reference frame RF connects the various components, and serves as a reference for setting and measuring positions of the patterning device and substrate and of features on them.

The illumination system may include various types of optical components, such as refractive, reflective, magnetic, electromagnetic, electrostatic or other types of optical components, or any combination thereof, for directing, shaping, or controlling radiation.

The patterning device support MT holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support MT may be a frame or a table, for example, which may be fixed or movable as required. The patterning device support may ensure that the patterning device is at a desired position, for example with respect to the projection system.

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

As here depicted, the apparatus is of a transmissive type (e.g., employing a transmissive patterning device). Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems.

In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may comprise an adjuster AD for adjusting the angular intensity distribution of the radiation beam. Generally, at least the outer and/or inner radial extent (commonly referred to as σ-outer and σ-inner, respectively) of the intensity distribution in a pupil plane of the illuminator may be adjusted. In addition, the illuminator IL may comprise various other components, such as an integrator IN and a condenser CO. The illuminator IL may be used to condition the radiation beam B, to have a desired uniformity and intensity distribution in its cross section.

The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

The lithographic apparatus may comprise an aberration sensor for the verification of an aberration fingerprint of the projection system PS. In an embodiment such an aberration fingerprint, i.e. aberrations per field point of the projection system PS, may be determined using a such wavefront aberration sensor. A wavefront aberration sensor of a known type, for instance such as described in US2002/0001088 may be used. Such a wavefront aberration sensor may be based on the principle of shearing interferometry and comprises a source module and a sensor module. The source module may comprise a patterned layer of chromium that is placed in the object plane (i.e. where during production the pattern of the patterning means is) of the projection system PS and has additional optics provided above the chromium layer. The combination provides a wavefront of radiation to the entire pupil of the projection system PS. The sensor module may comprise a patterned layer of chromium that is placed in the image plane of the projection system (i.e. where during production the substrate W is) and a camera that is placed some distance behind said layer of chromium. The patterned layer of chromium on the sensor module diffracts radiation into several diffraction orders that interfere with each other giving rise to an interferogram. The interferogram is measured by the camera. The aberrations in the projection lens can be determined by software based upon the measured interferogram.

The wavefront aberration sensor may be configured to transfer information with respect to the aberration fingerprint towards the control unit.

Patterning device (e.g., mask) MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment marks may also be included within dies, in amongst the device features, in which case it is desirable that the markers be as small as possible and not require any different imaging or process conditions than adjacent features. The alignment system, which detects the alignment markers is described further below.

The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned.

Combinations and/or variations on the above described modes of use or entirely different modes of use may also be employed.

Lithographic apparatus LA is of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. The preparatory steps may include mapping the surface height contours of the substrate using a level sensor LS and measuring the position of alignment markers on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

The lithographic apparatus control unit LACU which controls all the movements and measurements of various actuators and sensors to receive substrates W and reticles MA and to implement the patterning operations. Lithographic apparatus control unit LACU also includes signal processing and data processing capacity to implement desired calculations relevant to the operation of the apparatus, e.g., based on *inter alia* level sensor LS data, alignment sensor AS data and feedback metrology data (e.g., one or more of *inter alia* overlay, focus, dose, critical dimension data). In practice, control unit LACU may be realized as a system of many sub-units, each handling the real-time data acquisition, processing and control of a subsystem or component within the apparatus.

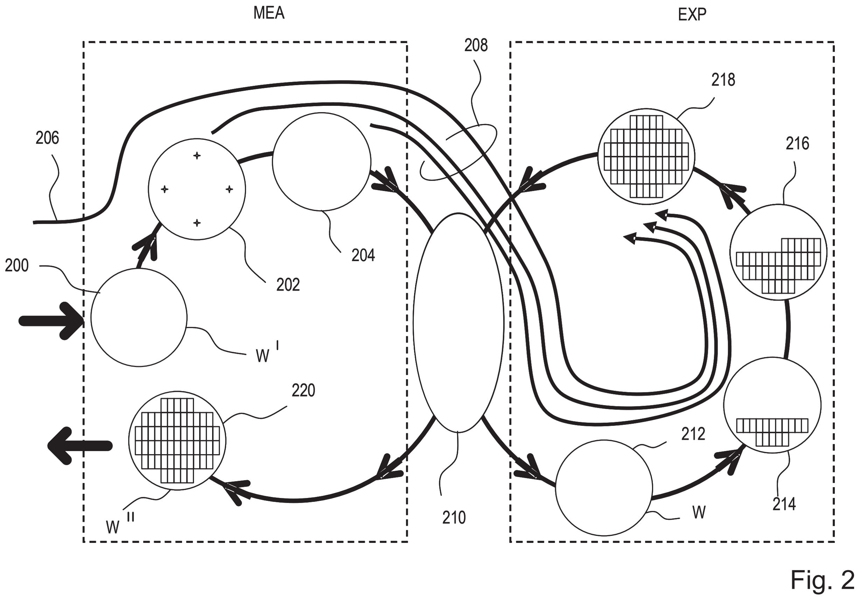

Figure 2 illustrates the steps to expose target portions (e.g. dies) on a substrate W in the dual stage apparatus of Figure 1. On the left hand side within a dotted box are steps performed at a measurement station MEA, while the right hand side shows steps performed at the exposure station EXP. From time to time, one of the substrate tables WTa, WTb will be at the exposure station, while the other is at the measurement station, as described above. For the purposes of this description, it is assumed that a substrate W has already been loaded into the exposure station. At step 200, a new substrate W' is loaded to the apparatus by a mechanism not shown. These two substrates are processed in parallel in order to increase the throughput of the lithographic apparatus.

Referring initially to the newly-loaded substrate W', this may be a previously unprocessed substrate, prepared with a new photo resist for first time exposure in the apparatus. In general, however, the lithography process described will be merely one step in a series of exposure and processing steps, so that substrate W' has been through this apparatus and/or other lithography apparatuses, several times already, and may have subsequent processes to undergo as well. Particularly for the problem of improving overlay performance, the task is to ensure that new patterns are applied in exactly the correct position on a substrate that has already been subjected to one or more cycles of patterning and processing. These processing steps progressively introduce distortions in the substrate that must be measured and corrected for, to achieve satisfactory overlay performance.

The previous and/or subsequent patterning step may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation.

At 202, alignment measurements using the substrate marks P1 etc. and image sensors (not shown) are used to measure and record alignment of the substrate relative to substrate table WTa/WTb. In addition, several alignment marks across the substrate W' will be measured using alignment sensor AS. These measurements are used in one embodiment to establish a "wafer grid", which maps very accurately the distribution of marks across the substrate, including any distortion relative to a nominal rectangular grid.

At step 204, a map of wafer height (Z) against X-Y position is measured also using the level sensor LS. Conventionally, the height map is used only to achieve accurate focusing of the exposed pattern. It may be used for other purposes in addition.

When substrate W' was loaded, recipe data 206 were received, defining the exposures to be performed, and also properties of the wafer and the patterns previously made and to be made upon it. To these recipe data are added the measurements of wafer position, wafer grid and height map that were made at 202, 204, so that a complete set of recipe and measurement data 208 can be passed to the exposure station EXP. The measurements of alignment data for example comprise X and Y positions of alignment targets formed in a fixed or nominally fixed relationship to the product patterns that are the product of the lithographic process. These alignment data, taken just before exposure, are used to generate an alignment model with parameters that fit the alignment model to the data. These parameters and the alignment model will be used during the exposure operation to correct positions of patterns applied in the current lithographic step. The model in use interpolates positional deviations between the measured positions. A conventional alignment model might comprise four, five or six parameters, together defining translation, rotation and scaling of the 'ideal' grid, in different dimensions. Advanced models are known that use more parameters.

At 210, wafers W' and W are swapped, so that the measured substrate W' becomes the substrate W entering the exposure station EXP. In the example apparatus of Figure 1, this swapping is performed by exchanging the supports WTa and WTb within the apparatus, so that the substrates W, W' remain accurately clamped and positioned on those supports, to preserve relative alignment between the substrate tables and substrates themselves. Accordingly, once the tables have been swapped, determining the relative position between projection system PS and substrate table WTb (formerly WTa) is all that is necessary to make use of the measurement information 202, 204 for the substrate W (formerly W') in control of the exposure steps. At step 212, reticle alignment is performed using the mask alignment marks M1, M2. In steps 214, 216, 218, scanning motions and radiation pulses are applied at successive target locations across the substrate W, in order to complete the exposure of a number of patterns.

By using the alignment data and height map obtained at the measuring station in the performance of the exposure steps, these patterns are accurately aligned with respect to the desired locations, and, in particular, with respect to features previously laid down on the same substrate. The exposed substrate, now labeled W" is unloaded from the apparatus at step 220, to undergo etching or other processes, in accordance with the exposed pattern.

The skilled person will know that the above description is a simplified overview of a number of very detailed steps involved in one example of a real manufacturing situation. For example rather than measuring alignment in a single pass, often there will be separate phases of coarse and fine measurement, using the same or different marks. The coarse and/or fine alignment measurement steps can be performed before or after the height measurement, or interleaved.

In a lithographic apparatus, it is known to control machine settings, e.g., lens settings and (reticle and substrate) stage settings, during exposures onto a substrate to optimize the projected image in terms of one or more placement parameters of interest, e.g., parameters related to placement of structures on the substrate. Such placement parameters of interest may comprise parameters on which device functionality and yield are dependent. In particular, the machine settings typically controlled include *inter alia* stage settings, lens control settings (e.g., to correct for lens aberration) and dose control settings. Stage settings may describe a planned or set stage movement such as described by various stage setpoints determined by the control hardware and software (e.g., as controlled by lithographic apparatus control unit LACU). These may relate to stage positioning, speed, and/or acceleration in each of the substrate plane (e.g., for placement/overlay control) and perpendicular to the substrate plane (e.g., for focus control).

In this manner, parameters of interest such as one or more of overlay, focus, and imaging (e.g., critical dimension (CD)) may be optimized. Such an optimization may comprise some trade-off between some of these parameters, but which ensure that each of these parameters of interest remain within-specification (e.g., within a tolerance indicative of a yielding or functional device). As such, "optimize" in the concept of this disclosure may simply mean improve and/or ensure that the parameter is within-specification. Of particular relevance to this disclosure are placement parameters of interest relating to structure placement, e.g., overlay.

Substrate tables (sometimes called substrate/-wafer clamps and hereafter referred to as wafer tables) are used for holding a substrate (hereafter referred to as a wafer) within a lithography apparatus during measurement (i.e., alignment metrology) and exposure of the wafer in the production of integrated circuits. The functional flatness of the wafer table (i.e., the flatness of the wafer table relevant to the wafer top surface flatness when the wafer is clamped onto the wafer table) is a significant contributor to one or more parameters of interest such as overlay error, as this functional flatness has an impact on the alignment data on which the exposure is based. This poses a potential limitation on the future miniaturization of integrated circuit structures if not addressed. The wafer table functional flatness may describe the flatness of the support surface (clamping surface) to which the wafer is clamped, i.e., the surface defined by an array of burls which support the wafer.

The functional flatness of the wafer tables is presently measured during and after production of the wafer table, and after integration of the wafer table into the lithography apparatus. A metrology wafer is utilized in the process of qualifying the functional flatness of wafer tables; i.e., the measurement of the wafer table functional flatness is measured indirectly by measuring the topography of a wafer clamped to the wafer table. The impact of this wafer on the flatness measurement is accounted for by subtracting a total thickness variation distribution (e.g., a TTV map) describing the variation in the total thickness of the wafer from the measured topography (e.g., height map). Other contributors may also be subtracted from the measured topography such as the contribution of the mirror block/encoder block, which typically supports the wafer table.

The subtraction of the TTV map from the measured topography therefore aims to accurately remove the influence of the wafer's inherent (un)flatness, enabling the wafer table's functional flatness to be distinguished from the wafer flatness. The TTV map is typically measured separately, typically in advance; i.e., it is typically provided by the wafer supplier (i.e., along with the wafer's freeform shape). The TTV map is typically provided as a single map which describes the sum of the respective topographies of both surfaces of the wafer.

It has been shown that using different wafers (of the same kind) to perform such wafer table flatness measurements (e.g., to measure the wafer table's functional flatness) results in a decrease in reproducibility compared to measurements conducted with the same wafer. This suggests that the current methodology, based on subtracting the TTV map from the measured topography, does not fully eliminate the wafer's contribution to flatness. It can be appreciated that this not only diminishes reproducibility (statistical errors) but also increases systematic measurement errors. For example, the measured wafer table flatness may be used to determine a wafer table flatness correction (e.g., a fine correction step, for example using ion-beam figuring, to improve the table flatness), and therefore any measurement errors are potentially directly "imprinted" into the flatness of the wafer table. This is difficult (or impossible) to correct in subsequent correction steps, therefore limiting the final performance of the wafer tables.

Additionally, wafer table flatness metrology as described herein may be performed within the lithographic apparatus (e.g., wafer table qualification) to determine corrections for alignment metrology data (i.e., to remove the wafer table impact). Therefore any error in the characterization of the wafer table flatness will be a contributor to alignment error. The concepts disclosed herein are equally applicable to wafer table topography (flatness) metrology in the context of wafer table production/installation and in the context of wafer table qualification for alignment correction.

The TTV map of the wafer accurately reflects the wafer's impact on flatness only at the points at which the wafer is supported by the wafer table. However, the wafer table clamping surface is defined by an array of protrusions known as burls, such that the wafer is supported on these burls. The burls define a clamping surface which comprises a cumulative area of only a very small fraction (e.g., about 1%) of the total surface of the wafer. As a consequence, flatness features on the bottom surface of the wafer, which are situated between the burl locations, do not fully "print through" to the top surface.

The limitation of the TTV approach is particularly evident when the two surfaces of a metrology wafer exhibit very different topographies, as is often the case. For example, it is known for wafers to comprise, on only one surface, high-frequency unflatness with one or more overlay-relevant spatial wavelengths between (for example) 2 and 5 mm. This is probably due to the different levels of polishing performed on the respective surfaces of the wafer during its production. Whatever the cause, if one surface of the wafer displays significant high-frequency flatness content while the other surface does not, applying the TTV correction effectively addresses only one surface, potentially diminishing the flatness on the opposite surface.

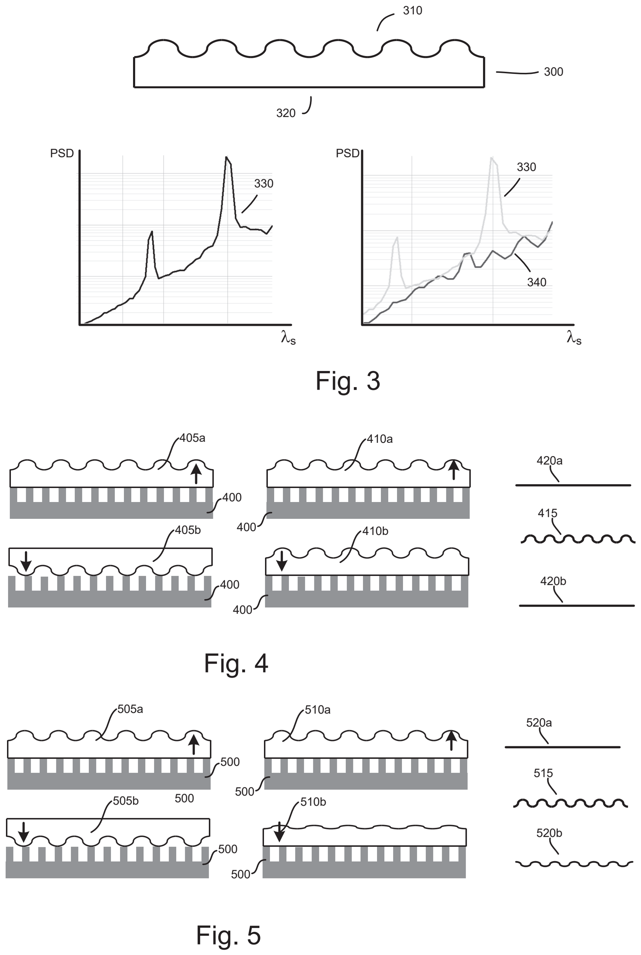

Figure 3 illustrates a wafer 300 having the type of flatness characteristics just described. Wafer 300 comprises a first surface 310 comprising a high-frequency, periodic unflatness and a second surface 320 without this high-frequency, periodic unflatness (i.e., better flatness). Plot 340 and plot 350 are plots of power spectral density PSD against spatial wavelength $\lambda_s$ respectively for the first surface 310 and second surface 320. It can be seen that, in first surface plot 340, there are distinct peaks centered on, in this example, two spatial wavelengths (e.g., each falling between 2mm and 5mm) while the second surface plot 350 displays no such peaks.

A wafer table functional flatness measurement may comprise the measurement of both surfaces of the wafer to enable cancellation of certain anti-symmetric effects; e.g., by averaging the measurements from the two surfaces. The present method is based on the assumptions that TTV is independent of the wafer orientation (i.e., in the context of this disclosure, wafer orientation refers to which surface of the wafer is facing up) and that the wafer error correction (i.e., removal of the TTV) removes the wafer impact completely.

Figure 4 illustrates the expected (i.e., ideal case) scenario for the present method of measuring wafer table functional flatness. Shown, on a wafer table 400, is the unclamped wafer oriented first surface topmost 405a, the unclamped wafer oriented second surface topmost 405b, the clamped wafer oriented first surface topmost 410a and the clamped wafer oriented second surface topmost 410b. The assumption is that the effect of clamping the wafer to the wafer table 400 (e.g., electrostatically or with vacuum) will result in the bottom surface unflatness fully "printing through" (e.g., being transferred) to the top surface, as illustrated by comparing wafers 405b (unclamped) and 410b (clamped). Because of this, for both wafer orientations, the measured flatness of the clamped wafer 410a, 410b corresponds with the TTV 415. This means that the TTV 415, for this idealized example, is independent of the wafer orientation and that the wafer error correction will remove the full wafer flatness. Therefore, the wafer table functional flatness 420a, 420b is fully corrected for the wafer topography for both orientations, here illustrated by a flat line; i.e., this example assumes a perfectly flat wafer table for clarity.

Figure 5, however, illustrates a more typical example of a wafer table flatness measurement using the present method, such as may occur for example, when the flatness of the two surfaces is very different (e.g., as illustrated in Figure 3), or more generally when the wafer impact on the wafer table's functional flatness is not truly independent of the wafer orientation.

Shown, on a wafer table 500, is the unclamped wafer oriented first surface topmost 505a, the unclamped wafer oriented second surface topmost 505b, the clamped wafer oriented first surface topmost 510a and the clamped wafer oriented second surface topmost 510b. In this example, the assumption that the effect of clamping the wafer to the wafer table 500 will result in the bottom surface unflatness fully "printing through" (e.g., being transferred) to the top surface is false. Because of this, for the first surface down wafer orientation, the measured shape of the clamped wafer 510b is substantially less than the TTV 515. Due mainly to the wafer being supported over a small area on burls, there is a mechanical damping of the high-frequency, second surface unflatness of the wafer. This means that high frequency features are falsely mapped onto the functional clamp flatness 520b by the TTV correction for the second orientation. As such, the functional wafer table flatness 520a is fully corrected for the wafer topography for the first orientation, but not for the second orientation (e.g., this example again assumes a perfect wafer table for clarity). Therefore, even after averaging over the two orientations, there will be a wafer topography component comprised in the measured wafer table topography.

The example of Figure 5 still assumes that the functional wafer table flatness is properly corrected in the first orientation (e.g., first surface up, where the first surface comprises the high spatial frequency components). However, separately to the above-described issue, it has sometimes been observed that the high spatial frequency components are suppressed in the TTV map used for the wafer error correction. This is believed to be due to limited sampling resolution in combination with subsequent interpolation when determining the TTV map (e.g., at the wafer supplier). This means that the TTV map does not completely remove the wafer impact when subtracted from the measured wafer topography data.

As such, a method of measuring a flatness metric (e.g., functional flatness) of a substrate support (e.g., wafer table) is described which addresses one or both of the issues described above. Instead of applying the same correction (i.e., the TTV map) to the metrology data obtained from measurement of both surfaces of the wafer, a side-specific topography-based wafer error correction is proposed. For each of first metrology data from the first surface measurement of the wafer and second metrology data from the second surface measurement of the wafer, such a side-specific topography-based wafer error correction comprises a combination (e.g., the sum) of the topography of the surface being measured (i.e., the top surface topography data) and a processed topography of the other surface (i.e., the bottom surface processed topography data), where the bottom surface processed topography data has been processed by application of a print-through function (first transfer function) which removes and/or damps topography from the bottom surface which does not transfer to the top surface when the substrate is clamped. In this way the transfer function mitigates for imperfect print-through of topography from bottom to top when clamping the wafer.

Optionally, the proposed method may also comprise processing the measured/top surface topography to obtain top surface processed topography data and combining the top surface processed topography data with the bottom surface processed topography data to determine the side-specific topography-based wafer error correction. Such a processing may comprise the application of a top surface transfer function (e.g., an enhancement filter) which enhances features suppressed in the TTV map.

The print-through function applied to process the bottom surface topography to obtain the bottom surface processed topography may comprise, in a simple example, a low pass filter in the spatial domain which passes lower spatial frequencies, i.e., so as to suppress spatial wavelengths below a threshold (e.g., spatial wavelengths below 10mm, below 8mm, below 6mm or below 5mm). However, in other examples, a model-based print-through transfer function may be used. Such a model-based print-through transfer function may take into account factors such as the burl pattern (burl positions and/or spacing) and one or more material properties of the wafer table and/or wafer (e.g., stiffness of the wafer and/or burls). Alternatively or in addition, the transfer function (whether model based or filter based) may be determined heuristically, i.e., based on performance (e.g., one or more of PSD model performance, overlay performance and/or performance according to another parameter of interest). For example, the print-through transfer function may be assessed by determining whether it removes peaks in the PSD spectrum (spatial wavelength/frequency spectrum) and/or whether overlay or other parameter of metric is improved by application of the function (e.g., as optimized/assessed in simulation and/or via measurement). In the latter case, this may be assessed by measuring/simulating overlay with any control/correction based on the wafer table flatness as calculated using the proposed wafer error correction. The function can be optimized to improve such metrics (e.g., which maximizes peak removal and/or minimizes overlay). By way of a specific example, the print-through transfer function may be determined via Finite Element Method (FEM) simulations which account for the geometry, topography, burl positions and stiffnesses of both the wafer and wafer table.

Each side-specific topography-based wafer error correction may be based on the total thickness variation data (e.g., TTV map $TTV$) and substrate shape data (freeform wafer shape data $f_{shape}$), e.g., as typically provided by the wafer supplier. For example, the first surface topography ($h_1$) and the second surface topography ($h_2$) can be calculated from this information using the following equations:

$$h_1 = \frac{TTV}{2} + f_{shape}$$

$$h_2 = \frac{TTV}{2} - f_{shape}$$

Using the proposed topography-based approach, all features that do not print through to the wafer's top surface are first removed from the bottom surface topography using a print-through flatness function ($PTF$). The resulting processed second surface topography $PTF$ ($h_2$) is then added to the first surface topography to generate the wafer error correction map. This is done separately for both surfaces to determine the first surface error correction (i.e., for first surface up) $SWEC_1$ and second surface error correction (i.e., for second surface up) $SWEC_2$, where the latter is the sum of the second surface topography $h_2$ and processed first surface topography $PTF(h_1)$. As such the side-specific wafer error correction may be defined as:

$$SWEC_1 = h_1 + PTF(h_2)$$

$$SWEC_2 = h_2 + PTF(h_1)$$

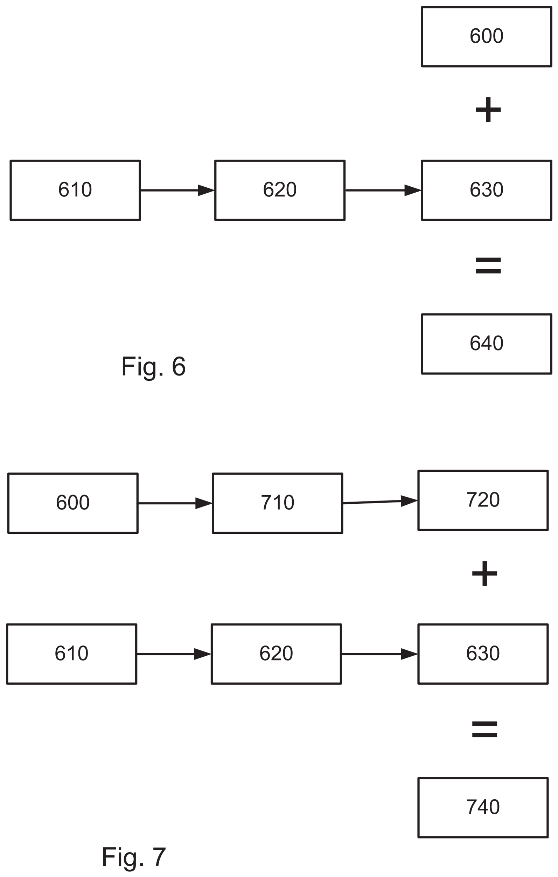

Figure 6 is a flowchart describing a method according to such an embodiment. The flowchart describes the method of determining the side-specific topography-based wafer error correction for only one surface, and may be performed for both orientations of the wafer (i.e., such that respectively the first surface and second surface of the wafer is the top surface) and the results averaged. Top surface topography data 600 and bottom surface topography data 610 is obtained, e.g., as determined from the TTV data and freeform wafer shape data as described. A first transfer function or print through transfer function 620 is applied to the bottom surface topography data 610 to obtain processed bottom surface topography data 630. The side-specific topography-based wafer error correction 640 is determined as the sum of the top surface topography data 600 and processed bottom surface topography data 630.

Figure 7 is a flowchart describing the same method as that of Figure 6, but where a second transfer function 710 is applied to the top surface topography data 600 to obtain processed top surface topography data 720. The side-specific topography-based wafer error correction 730 is determined as the sum of the processed top surface topography data 720 and processed bottom surface topography data 630. The second transfer function 710 may comprise, for example, a summation of the bottom surface topography data with high pass filtered bottom surface topography data, thereby enhancing or amplifying high spatial frequency components, i.e., spatial wavelengths below a threshold (e.g., spatial wavelengths below 10mm, below 8mm, below 6mm or below 5mm). This is to enhance top features which may have been damped in the TTV data.

Optionally, second transfer function 710 is not applied in an edge region of the wafer, and further optionally may be applied gradually in a transition zone between the edge region and main central region. These characteristics may equally be applied to the first transfer function 620, i.e., when implemented as a low pass filter.

Once determined, the first surface error correction can be applied to a wafer table flatness metrology data measured via the wafer oriented first surface up and the second surface error correction can be applied to a wafer table flatness metrology data measured via the wafer oriented second surface up. This provides an improved method for correcting the wafer table flatness metrology data for the wafer topography compared to the present method of subtracting the TTV map. The corrected wafer table flatness metrology data for both orientations can then be averaged to provide an averaged wafer table flatness measurement.

The proposed method ensures that spatial frequencies present only on one surface of the wafer are excluded from the final wafer table height map, thereby eliminating their influence on the estimated overlay error.

By applying this technique during final wafer table qualification, unnecessary rework is minimized, and the risk of imprinting non-critical wafer structures into the wafer table through finecorrection processes is avoided. This improvement will lead to shorter cycle times, more effective fine correction processes, and a decreased contribution of wafer tables to the overall flatness and overlay budget of lithography scanners

The following numbered clauses describe various aspects of the invention:

1. A method of measuring a topography of a substrate support, the method comprising:

obtaining metrology data describing a topography of a substrate when clamped to the substrate support, the substrate when clamped comprising a bottom surface clamped against the substrate support and a top surface which is measured to obtain the measurement data;
obtaining top surface topography data describing a topography of the top surface of the substrate and bottom surface topography data describing a topography of the bottom surface of the substrate;
applying a first transfer function to the bottom surface topography data to obtain processed bottom surface topography data, the first transfer function removing and/or damping topography from the bottom surface which does not transfer to the top surface when the substrate is clamped;
determining corrected metrology data, corrected for a contribution of the metrology data attributable to the substrate, from a combination of the top surface topography data and the processed bottom surface topography data; and
determining the topography of the substrate support from the corrected metrology data.

2. A method according to clause 1, wherein the corrected metrology data is determined from a sum of the top surface topography data and the processed bottom surface topography data.

3. A method according to clause 1 or 2, wherein the metrology data comprises first metrology data describing the topography of the substrate when clamped to the substrate support in a first orientation such that a first surface of the substrate comprises the top surface and second metrology data describing the topography of the substrate when clamped to the substrate support in a second orientation such that a second surface of the substrate comprises the top surface;

wherein the steps of applying a first transfer function to the bottom surface topography data and determining corrected metrology data are performed separately for each of the first metrology data and second metrology data to corrected first metrology data and corrected second metrology data; and

wherein the step of determining the topography of the substrate support comprises determining the topography of the substrate support from the corrected first metrology data and the corrected second metrology data.

4. A method according to clause 3, wherein the step of determining the topography of the substrate support comprises determining the topography of the substrate support from an average of the corrected first metrology data and the corrected second metrology data.

5. A method according to any preceding clause, wherein the first transfer function comprises a low pass filter function which suppresses one or more components of the metrology data comprising spatial wavelengths in the spatial domain which are below a threshold spatial wavelength.

6. A method according to any of clauses 1 to 4, wherein the first transfer function comprises a model transfer function determined from at least a geometry of the substrate table.

7. A method according to clause 6, wherein the model transfer function is determined from at least a location of burls on the substrate table.

8. A method according to clause 6 or 7, wherein the model transfer function determined from at least one or more material properties of the substrate table and/or substrate.

9. A method according to any preceding clause, comprising a step of determining the first transfer function heuristically.

10. A method according to any preceding clause, comprising applying a second transfer function to the top surface topography data to obtain processed top surface topography data, the second transfer function amplifying and/or enhancing one or more components of the top surface topography data;

wherein the correcting step comprises correcting the metrology data for a topography of the substrate from a combination of the processed first surface topography data and the processed second surface topography data, to obtain the corrected metrology data.

11. A method according to clause 10, wherein the second transfer function operates to sum the top surface topography data with high pass filtered top surface topography data.

12. A method according to any preceding clause, comprising determining top surface topography data and the bottom surface topography data from total thickness variation data and freeform shape data of the substrate.

13. A method according to any preceding clause, comprising performing a substrate support correction step to improve a flatness of the substrate support based on the determined topography of the substrate support.

14. A method according to any of clauses 1 to 12, comprising determining a correction for alignment data measured from a production substrate clamped to the substrate support based on the determined topography of the substrate support, to obtain corrected alignment data.

15. A method according to clause 14, comprising performing an exposure on the production substrate based on the corrected alignment data.

16. A computer program comprising program instructions operable to perform the method of any of clauses 1 to 15, when run on a suitable apparatus.

17. A non-transient computer program carrier comprising the computer program of clause 16.

18. A processing arrangement comprising:

a non-transient computer program carrier comprising a computer program according to clause 17; and

a processor operable to run the computer program comprised on said non-transient computer program carrier.

19. A manufacturing apparatus comprising the processing arrangement of clause 18.

20. A manufacturing apparatus being operable to perform the method of any of clauses 1 to 15.

21. A manufacturing apparatus according to clause 19 or 20, comprising a lithographic exposure apparatus or an ion beam figuring apparatus.

While specific embodiments of the invention have been described above, it will be appreciated that the invention may be practiced otherwise than as described.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 1-100 nm), as well as particle beams, such as ion beams or electron beams.

The term "lens", where the context allows, may refer to any one or combination of various types of optical components, including refractive, reflective, magnetic, electromagnetic and electrostatic optical components. Reflective components are likely to be used in an apparatus operating in the UV and/or EUV ranges.

The breadth and scope of the present invention should not be limited by any of the above-described exemplary embodiments, but should be defined only in accordance with the following claims and their equivalents.

## Claims

1. A method of measuring a topography of a substrate support, the method comprising:

   obtaining metrology data describing a topography of a substrate when clamped to the substrate support, the substrate when clamped comprising a bottom surface clamped against the substrate support and a top surface which is measured to obtain the measurement data;
   obtaining top surface topography data describing a topography of the top surface of the substrate and bottom surface topography data describing a topography of the bottom surface of the substrate;
   applying a first transfer function to the bottom surface topography data to obtain processed bottom surface topography data, the first transfer function removing and/or damping topography from the bottom surface which does not transfer to the top surface when the substrate is clamped;
   determining corrected metrology data, corrected for a contribution of the metrology data attributable to the substrate, from a combination of the top surface topography data and the processed bottom surface topography data; and
   determining the topography of the substrate support from the corrected metrology data.

2. A method as claimed in claim 1, wherein the corrected metrology data is determined from a sum of the top surface topography data and the processed bottom surface topography data.

3. A method as claimed in claim 1 or 2, wherein the metrology data comprises first metrology data describing the topography of the substrate when clamped to the substrate support in a first orientation such that a first surface of the substrate comprises the top surface and second metrology data describing the topography of the substrate when clamped to the substrate support in a second orientation such that a second surface of the substrate comprises the top surface;

   wherein the steps of applying a first transfer function to the bottom surface topography data and determining corrected metrology data are performed separately for each of the first metrology data and second metrology data to corrected first metrology data and corrected second metrology data; and
   wherein the step of determining the topography of the substrate support comprises determining the topography of the substrate support from the corrected first metrology data and the corrected second metrology data.

4. A method as claimed in claim 3, wherein the step of determining the topography of the substrate support comprises determining the topography of the substrate support from an average of the corrected first metrology data and the corrected second metrology data.

5. A method as claimed in any preceding claim, wherein the first transfer function comprises a low pass filter function which suppresses one or more components of the metrology data comprising spatial wavelengths in the spatial domain which are below a threshold spatial wavelength.

6. A method as claimed in any of claims 1 to 4, wherein the first transfer function comprises a model transfer function determined from at least a geometry of the substrate table.

7. A method as claimed in claim 6, wherein the model transfer function is determined from at least:

   a location of burls on the substrate table; and/or
   one or more material properties of the substrate table and/or substrate.

8. A method as claimed in any preceding claim, comprising a step of determining the first transfer function heuristically.

9. A method as claimed in any preceding claim, comprising applying a second transfer function to the top surface topography data to obtain processed top surface topography data, the second transfer function amplifying and/or enhancing one or more components of the top surface topography data;
   wherein the correcting step comprises correcting the metrology data for a topography of the substrate from a combination of the processed first surface topography data and the processed second surface topography data, to obtain the corrected metrology data.

**10.** A method as claimed in claim 9, wherein the second transfer function operates to sum the top surface topography data with high pass filtered top surface topography data.

**11.** A method as claimed in any preceding claim, comprising determining top surface topography data and the bottom surface topography data from total thickness variation data and freeform shape data of the substrate.

**12.** A method as claimed in any preceding claim, comprising performing a substrate support correction step to improve a flatness of the substrate support based on the determined topography of the substrate support.

**13.** A method as claimed in any of claims 1 to 11, comprising determining a correction for alignment data measured from a production substrate clamped to the substrate support based on the determined topography of the substrate support, to obtain corrected alignment data.

**14.** A computer program comprising program instructions operable to perform the method of any of claims 1 to 13, when run on a suitable apparatus.

**15.** A manufacturing apparatus comprising:

a non-transient computer program carrier comprising a computer program as claimed in claim 14; and
a processor operable to run the computer program comprised on said non-transient computer program carrier.

Fig. 1

Fig. 2

EP 4 722 809 A2

Fig. 3

Fig. 4

Fig. 5

```
                                    ┌──────────────┐
                                    │     600      │
                                    └──────────────┘

                                          +

┌──────────────┐    ┌──────────────┐    ┌──────────────┐
│     610      │ →  │     620      │ →  │     630      │
└──────────────┘    └──────────────┘    └──────────────┘

                                          =

                                    ┌──────────────┐
                                    │     640      │
                                    └──────────────┘
```

Fig. 6

```
┌──────────────┐    ┌──────────────┐    ┌──────────────┐
│     600      │ →  │     710      │ →  │     720      │
└──────────────┘    └──────────────┘    └──────────────┘

                                          +

┌──────────────┐    ┌──────────────┐    ┌──────────────┐
│     610      │ →  │     620      │ →  │     630      │
└──────────────┘    └──────────────┘    └──────────────┘

                                          =

                                    ┌──────────────┐
                                    │     740      │
                                    └──────────────┘
```

Fig. 7

**REFERENCES CITED IN THE DESCRIPTION**

**Patent documents cited in the description**

- US 20020001088 A